# EUROPÄISCHE PATENTSCHRIFT

(11) **EP 4 211 538 B1**
(45) Veröffentlichungstag und Bekanntmachung des Hinweises auf die Patenterteilung: **19.02.2025**
(21) Anmeldenummer: 21755986.3
(22) Anmeldetag: 09.08.2021
(51) Int. Cl.: G06F 3/01, G06F 3/0354, G06F 3/041, H03K 17/975, G06F 3/044

(54) **AKTUATOREINHEIT**
ACTUATOR UNIT
UNITÉ D'ACTIONNEMENT

(30) Priorität: 08.09.2020 DE 102020123436
(43) Veröffentlichungstag der Anmeldung: 19.07.2023
(73) Patentinhaber: Next System Vertriebsges.m.b.H., 1210 Wien (AT)
(72) Erfinder: NUSSBAUMER, Michael, 4690 Pitzenberg (AT)
(74) Vertreter: Lohmanns Lohmanns & Partner mbB
(86) Internationale Anmeldenummer: PCT/EP2021/072182
(87) Internationale Veröffentlichungsnummer: WO 2022/053240

(56) Entgegenhaltungen:
- WO-A1-2019/230634
- DE-A1- 102018 101 145
- FR-A1- 3 039 671
- US-A1- 2012 327 025
- US-A1- 2018 081 483
- US-A1- 2019 391 677
- US-B1- 10 459 542

## Beschreibung

Die Erfindung betrifft eine Aktuatoreinheit zur Erzeugung eines haptischen Feedbacks an einer Mensch-Maschine-Schnittstelle gemäß dem Oberbegriff des Anspruchs 1. Die Aktuatoreinheit weist wenigstens eine in Z-Richtung bewegliche Fläche und eine Druckmesseinrichtung zur Messung eines Drucks in Z-Richtung auf diese bewegliche Fläche auf. Ferner ist eine Feedbackkomponente vorgesehen, die dazu ausgebildet ist, in Reaktion auf einen durch die Druckmesseinrichtung gemessenen Druck ein haptisches Feedback auf die bewegliche Fläche zu übertragen. Die Aktuatoreinheit weist Kontaktierungsmittel zum Anschluss einer Kontrolleinheit auf, die dazu ausgebildet ist, Druckmesswerte der Druckmesseinrichtung zu empfangen und auszuwerten, und die Feedbackkomponente über die Kontaktierungsmittel anzusteuern, ein haptisches Feedback zu erzeugen, falls ein empfangener Druckmesswert einen Grenzwert übersteigt.

Eine solche Aktuatoreinheit kann in verschiedenen Anwendungsgebieten eingesetzt werden, um bei einem bestimmten Druck auf eine Fläche einer Mensch-Maschine-Schnittstelle ein haptisches Feedback an der Fläche zu erzeugen. Dies kann insbesondere vorteilhaft eingesetzt werden, um bei einem Nutzer die Wahrnehmung einer mechanischen Drucktaste zu erzeugen. Das haptische Feedback kann dabei von einer Feedbackkomponente auf verschiedene Arten erzeugt werden, wobei beispielsweise piezoelektrische, elektromagnetische und/oder elektrostatische Effekte genutzt werden, um eine Fläche kurzzeitig aus einer Ruhelage in eine ausgelenkte Lage zu bewegen. Für die Druckmessung können ebenfalls verschiedene physikalische Effekte genutzt werden, wobei beispielsweise eine kapazitive Druckmessung verwendet werden kann.

Insbesondere wird ein solches haptisches Feedback in elektronischen Geräten an einem Touchpad oder einem Touchscreen vorgesehen. Hierzu wird oftmals unterhalb einer berührungssensitiven Fläche eines elektronischen Gerätes ein komplexer Schichtaufbau aus mehreren Funktionsschichten vorgesehen, wie es beispielsweise in der US 2019/0391677 A1 offenbart ist. Ein solcher Schichtaufbau ist jedoch fest in das elektronische Gerät integriert und stellt kein eigenständiges, abgegrenztes Bauteil dar, welches z.B. an verschiedenen Positionen unter einer Anzeige platziert werden kann. Ähnliche Konstruktionen sind auch aus den Patentschriften FR 3 039 671 A1, US 2018/081483 A1, US 2012/327025 A1, DE 10 2018 101145 A1 und WO 2019/230634 A1 bekannt.

Aufgabe der Erfindung ist es, eine möglichst kompakt aufgebaute Aktuatoreinheit zur Erzeugung eines haptischen Feedbacks an einer beweglichen Fläche bereit zu stellen, die insbesondere als eigenständiges Bauteil an einer Mensch-Maschine-Schnittstelle eingesetzt werden kann.

Erfindungsgemäß wird diese Aufgabe durch eine Aktuatoreinheit gemäß dem unabhängigen Anspruch 1 gelöst. Vorteilhafte Weiterbildungen der Aktuatoreinheit ergeben sich aus den Unteransprüchen 2-14.

Es ist darauf hinzuweisen, dass die in den Ansprüchen einzeln aufgeführten Merkmale in beliebiger, technisch sinnvoller Weise miteinander kombiniert werden können und weitere Ausgestaltungen der Erfindung aufzeigen. Die Beschreibung charakterisiert und spezifiziert die Erfindung insbesondere im Zusammenhang mit den Figuren zusätzlich.

Die erfindungsgemäße Aktuatoreinheit ist zur Erzeugung eines haptischen Feedbacks an einer Mensch-Maschine-Schnittstelle ausgebildet. Unter einem haptischen Feedback versteht man im Sinne der vorliegenden Erfindung eine taktile Rückmeldung von Kraft an einen Nutzer, der mit der Hand, einem Finger oder einem mit der Hand betätigten Hilfsmittel Druck auf eine Fläche ausübt. Unter einer Mensch-Maschine-Schnittstelle versteht man im Sinne dieser Erfindung eine Schnittstelle, über welche ein Nutzer ein elektronisches Gerät bedienen und/oder steuern kann. Insbesondere wird dabei eine druck- und/oder berührungssensitive Fläche eingesetzt, über welche ein Nutzer durch Kontakt mit der Fläche ein elektronisches Gerät bedienen und/oder steuern kann. Diese Fläche kann auch als Kontaktfläche bezeichnet werden. Bei der zu berührenden Fläche handelt es sich beispielsweise um eine berührungssensitive Fläche eines Touchpads oder Touchscreens. Doch die Erfindung kann auch bei anderen Arten von Mensch-Maschine-Schnittstellen eingesetzt werden, bei denen ein haptisches Feedback vorteilhaft ist. Die taktile Rückmeldung erfolgt üblicherweise durch eine kurze Auslenkung der vom Nutzer berührten Fläche, insbesondere durch eine Vibration.

Die Aktuatoreinheit weist wenigstens eine in Z-Richtung bewegliche Fläche und eine Druckmesseinrichtung zur Messung eines Drucks in Z-Richtung auf diese bewegliche Fläche auf. Die Z-Richtung verläuft im Wesentlichen in einem Winkel von etwa 90° zur beweglichen Fläche. Ferner ist eine Feedbackkomponente vorgesehen, die dazu ausgebildet ist, in Reaktion auf einen durch die Druckmesseinrichtung gemessenen Druck ein haptisches Feedback auf die bewegliche Fläche zu übertragen, d.h. eine kurze Bewegung/Auslenkung des ersten Gehäuseteils aus einer Ruhelage in eine ausgelenkte Lage zu bewirken. Dabei kann die Feedbackkomponente eine einmalige oder mehrmalige Auslenkung der beweglichen Fläche bewirken. Geeignete Dämpfer- und Rückstellmechanismen bewirken ein gewünschtes Schwingverhalten der beweglichen Fläche. Die Aktuatoreinheit weist dazu Kontaktierungsmittel zum Anschluss einer Kontrolleinheit auf, die dazu ausgebildet ist, Druckmesswerte der Druckmesseinrichtung zu empfangen und auszuwerten, und die Feedbackkomponente anzusteuern, ein haptisches Feedback zu erzeugen, falls ein empfangener Druckmesswert einen Grenzwert übersteigt.

Bei dem Grenzwert kann es sich um einen fest in der Kontrolleinheit hinterlegten Druckwert handeln. In einer anderen Ausführungsform ist dieser Grenzwert an der Kontrolleinheit einstellbar, so dass verschiedene Grenzwerte eingestellt können bzw. zwischen verschiedenen Grenzwerten gewählt werden kann. Ferner ist es möglich, mehrere Grenzwerte zu definieren und diesen Grenzwerten verschiedene haptische Feedbacks zuzuordnen. Beispielsweise kann einem Nutzer bei einem leichten Druck auf eine Fläche eine andere taktile Rückmeldung gegeben werden als bei einem höheren Druck, wobei auch ein oder mehrere Zwischenstufen vorhanden sein können.

Erfindungsgemäß weist die Aktuatoreinheit wenigstens zwei Gehäuseteile auf, wobei ein erstes Gehäusesteil die bewegliche Fläche ausbildet, indem das erste Gehäuseteil gegenüber einem zweiten Gehäuseteil wenigstens in Z-Richtung beweglich angeordnet ist. Die Druckmesseinrichtung ist dann zur Messung eines Drucks in Z-Richtung auf das bewegliche Gehäuseteil ausgebildet. Die Feedbackkomponente ist zwischen den beiden Gehäuseteilen angeordnet und die Druckmesseinrichtung ist eine kapazitive Messeinrichtung, die räumlich getrennt von der Feedbackkomponente ebenfalls zwischen den beiden Gehäuseteilen angeordnet ist, um durch eine Bewegung des beweglichen ersten Gehäuseteils gegenüber dem zweiten Gehäuseteil in Z-Richtung eine kapazitive Druckmessung zu bewirken. Zur Bewegung des ersten Gehäuseteils gegenüber dem zweiten Gehäuseteil stützt sich die Feedbackkomponente an dem zweiten Gehäuseteil ab. Die Auslenkung einer Fläche kann grundsätzlich in Z-Richtung, d.h. in einem Winkel von 90° zur beweglichen Fläche, oder lateral erfolgen. Bei der erfindungsgemäßen Aktuatoreinheit erfolgt die Auslenkung in Z-Richtung, indem die Feedbackkomponente das erste bewegliche Gehäuseteil von dem zweiten Gehäuseteil wegdrückt.

Die Aktuatoreinheit ist erfindungsgemäß als eigenständiges Bauteil ausgebildet, das als Funktionskomponente in ein elektronisches Gerät eingebaut werden kann. Beispielsweise kann sie unterhalb einer Fläche eines Touchpads oder Touchscreens montiert werden, wobei die erste bewegliche Gehäusehälfte der Aktuatoreinheit mechanisch mit einer berührungssensitiven Fläche verbunden wird. In einer Ausführungsform der Erfindung werden mehrere Aktuatoreinheiten verbaut, wobei beispielsweise vier Aktuatoreinheiten in Frage kommen, die jeweils in einer Ecke einer Fläche angeordnet sind. Andere geeignete Anordnungen sind jedoch ebenfalls möglich. Bei Druck eines Nutzers auf die Fläche wird dieser Druck auf das erste Gehäuseteil übertragen, dessen Bewegung in Richtung des zweiten Gehäuseteils eine kapazitive Druckmessung durch die Druckmesseinrichtung bewirkt.

Die Druckmesseinrichtung erzeugt einen zugehörigen Druckmesswert, wobei es sich bei dem Druckmesswert nicht zwingend um den absoluten Wert eines Drucks handeln muss, sondern ein Druckmesswert kann auch durch einen anderen Parameter gegeben sein, welcher dem Wert eines bestimmten Drucks oder einer Druckänderung entspricht. Wenigstens dieser ermittelte Druckmesswert wird an die Kontrolleinheit übergeben. Übersteigt der ermittelte Druckmesswert einen bestimmten Grenzwert, wird von der Kontrolleinheit davon ausgegangen, dass es sich nicht nur um eine unbeabsichtigte Berührung eines Nutzers handelt, sondern um einen beabsichtigten Betätigungsdruck. Bei dieser Auswertung der Kontrolleinheit können weitere Parameter berücksichtigt werden. Die Kontrolleinheit steuert daraufhin über die Kontaktierungsmittel der Aktuatoreinheit die Feedbackkomponente an, welche die erste Gehäusehälfte der Aktuatoreinheit durch eine kurze Bewegung bzw. Vibration zu einem haptischen Feedback anregt. Diese Anregung wird auf die mit der ersten Gehäusehälfte verbundene Fläche der Mensch-Maschine-Schnittstelle übertragen. Dabei kann die Lage der Fläche translatorisch verändert werden, sie kippt um eine Achse und/oder die Fläche verformt sich lokal, indem sie sich beispielsweise durchbiegt. Die Fläche ist entsprechend gelagert und die erfindungsgemäße Aktuatoreinheit kann je nach Einbausituation flexibel eingesetzt werden.

Der erfindungsgemäße Aufbau einer Aktuatoreinheit hat den Vorteil, dass sich durch die beiden Gehäuseteile ein Gehäuse für ein kompaktes Bauteil bilden lässt. Die Gehäuseteile bestehen vorzugsweise aus einem nicht elektrisch leitenden Kunststoff und zwischen ihnen können die wesentlichen Funktionskomponenten der Aktuatoreinheit angeordnet werden. Dabei verschließt das erste bewegliche Gehäuseteil die Aktuatoreinheit auf einer Seite, dient aber auch zur Übertragung eines externen Drucks auf die kapazitive Druckmesseinrichtung und auch zur Übertragung eines haptischen Feedbacks auf eine damit verbundene Fläche. Das zweite Gehäuseteil kann beim Einbau fest mit ihrerseits unbeweglichen Teilen eines elektronischen Gerätes verbunden werden.

Dabei ist die kapazitive Druckmesseinrichtung ebenfalls zwischen den beiden Gehäuseteilen angeordnet, jedoch räumlich getrennt von der Feedbackkomponente, d.h. sie überlappen sich beispielsweise nicht. Dies hat insbesondere den Vorteil, dass beide Komponenten einfach und getrennt voneinander zu montieren sind. In einer Ausführungsform der Erfindung liegen die Druckmesseinrichtung und die Feedbackkomponente in Z-Richtung gesehen nebeneinander. Beide Komponenten können dann z.B. nebeneinander an dem zweiten Gehäuseteil positioniert werden, bevor das erste Gehäuseteil aufgesetzt wird, um die Aktuatoreinheit zu schließen. Beide Gehäuseteile sind vorzugsweise so ausgeformt, dass sich nach außen hin eine nahezu geschlossene Einheit bildet, die gut gehandhabt werden kann, ohne dass z.B. Einzelteile unerwünscht ihre Lage verändern.

Insgesamt lässt sich mit der Erfindung daher eine leicht zu montierende, kompakte Aktuatoreinheit bereitstellen, die in verschiedenen Anwendungsgebieten zum Einsatz kommen kann. Die Aktuatoreinheit lässt sich dabei flach beispielsweise mit geringen Höhen von bis zu 3 mm realisieren, was für die Verwendung in flachen Anzeigevorrichtungen von Vorteil ist. Aber auch größere Höhen können realisiert werden.

Dabei kann die Feedbackkomponente auf verschiedene Arten auf der Basis unterschiedlicher physikalischer Effekte ausgestaltet sein, um die erste Gehäusehälfte kurz in Bewegung oder sogar Schwingung zu versetzen. Beispielsweise umfasst die Feedbackkomponente eine Piezostruktur oder Schwingspule, die jeweils dazu ausgebildet ist, eine Bewegung des ersten Gehäuseteils in Z-Richtung zu bewirken. Bei einer Piezostruktur bewirkt das Anlegen einer Spannung aufgrund des Piezoeffektes eine mechanische Kraft, die auf das erste Gehäuseteil übertragen und zur Erzeugung eines haptischen Effekts genutzt wird. Bei einer Schwingspule (Tauchspule, Voice Coil) werden taktile Reize durch elektromagnetische Kraft übertragen.

In einer Ausführungsform der Erfindung umfasst die Aktuatoreinheit selbst einen Rückstellmechanismus, der dazu ausgebildet ist, das erste Gehäuseteil nach einer Auslenkung aus seiner Ruhelage in eine ausgelenkte Lage in seine Ruhelage rückzustellen. Der Rückstellmechanismus wirkt somit der Auslenkung des ersten Gehäuseteils von der Ruhelage in die ausgelenkte Lage entgegen. Der Rückstellmechanismus weist hierzu beispielsweise wenigstens ein Federelement auf, das unter Zugspannung zwischen dem ersten Gehäuseteil und dem zweiten Gehäuseteil eingespannt ist. Diese Integration eines Rückstellmechanismus in eine kompakte Aktuatoreinheit hat den Vorteil, dass die Rückstellung weniger stark abhängig ist von den Gegebenheiten der Einbausituation der Aktuatoreinheit. In einer alternativen Ausführungsform ist das wenigstens eine Federelement nicht zwischen den beiden Gehäuseteilen der Aktuatoreinheit gespannt, sondern zwischen dem beweglichen ersten Gehäuseteil und einem Teil einer Mensch-Maschine-Schnittstelle, in welche die Aktuatoreinheit eingebaut ist. In jedem Fall zieht das Federelement das erste Gehäuseteil in Richtung des zweiten Gehäuseteils.

In einer weiteren alternativen Ausführungsform ist hingegen vorgesehen, dass die Aktuatoreinheit so eingebaut wird, dass ein externer Rückstellmechanismus auf die beiden Gehäuseteile wirkt. Beispielsweise können äußere Federelemente einen Druck auf das erste Gehäuseteil und optional auch das zweite Gehäuseteil ausüben, um das erste Gehäuseteil nach einer Auslenkung durch die Feedbackkomponente in Richtung des zweiten Gehäuseteils rückzustellen.

In einer bevorzugten Ausführungsform der Erfindung ist zwischen der Feedbacckomponente und dem zweiten Gehäuseteil ferner wenigstens ein Dämpfungselement angeordnet, um das Schwingungsverhalten des Systems zu beeinflussen und dabei zu verbessern. Das Dämpfungselement ist beispielsweise ein Gummibauteil. Beispielsweise ist das Dämpfungselement wenigstens teilweise in einer Aufnahme innerhalb des zweiten Gehäuseteils aufgenommen. Bei der Aufnahme handelt es sich insbesondere um eine Senke im zweiten Gehäuseteil, welche an die Form und Größe des Dämpfungselementes angepasst ist. Dies trägt zur einfachen Montage der erfindungsgemäßen Aktuatoreinheit bei, da das Dämpfungselement vor der Montage der Feedbackkomponente in die Aufnahme eingelegt werden kann, wobei das Dämpfungselement dort in Position gehalten wird und insbesondere nicht seitlich verrutschen kann. Das Dämpfungselement ragt dabei über den Öffnungsrand der Aufnahme hinaus und kontaktiert in diesem Bereich die Unterseite der Feedbacckomponente. Die Lage des Dämpfungselementes kann jedoch auch auf andere Art an dem zweiten Gehäuseteil festgelegt werden.

Die kapazitive Druckmesseinrichtung weist in einer bevorzugten Ausführungsform der Erfindung wenigstens eine erste Elektrode und eine zweite Elektrode auf. Die erste Elektrode ist mechanisch mit dem ersten beweglichen Gehäuseteil verbunden, während die zweite Elektrode mechanisch mit dem zweiten Gehäuseteil verbunden ist. Zwischen den beiden Elektroden befindet sich wenigstens eine Schicht aus einem Dielektrikum, wobei dieses Dielektrikum auf verschiedene Arten ausgebildet sein kann. Die Druckmesseinrichtung ist in einer Ausführungsform der Erfindung so ausgebildet, dass sich der Abstand zwischen den beiden Elektroden bei einem Druck auf das erste Gehäuseteil verringert, wodurch eine sich ändernde Kapazität messbar ist, um daraus einen Druckmesswert zu ermitteln. In alternativen Ausführungsformen wird ein Aufbau mit entsprechenden Kraftumlenkungen gewählt, um bei einem Druck auf das erste Gehäuseteil den Abstand zwischen den beiden Elektroden zu erhöhen und aus einer sich ändernden Kapazität einen Druckmesswertwert zu ermitteln. Auch die Verformung einer Elektrode und/oder ein paralleles Verschieben der beiden Elektroden gegeneinander können für eine Druckermittlung genutzt werden. Zwei parallele Elektroden, die bei einer Krafteinwirkung auf die Elektrode am beweglichen Gehäuseteil aufeinander zu bewegt werden, haben jedoch den Vorteil, dass sie einfach auf den Innenseiten der beiden Gehäuseteile angebracht werden können.

In einer Ausführungsform der Erfindung ist die Feedbackkomponente ergänzend zur Erzeugung eines haptischen Feedbacks auch zur Messung eines Drucks auf das erste Gehäuseteil in Z-Richtung ausgebildet. Bei Druck auf das erste bewegliche Gehäuseteil drückt dieses auf die Feedbackkomponente, welche diesen Druck messen kann. Bei Verwendung von beispielsweise einer Piezostruktur, wird die Piezostruktur mechanisch zusammengedrückt, was als Spannungsänderung erfassbar und in einen Druckmesswert umwandelbar ist. Die Feedbackkomponente dient dann nicht nur zur Erzeugung eines haptischen Feedbacks, sondern sie kann optional auch zur Druckmessung eingesetzt werden. Bei einer Piezostruktur werden sowohl der direkte piezoelektrische Effekt als auch der inverse piezoelektrische Effekt genutzt. Bei Druck auf das erste bewegliche Gehäuseteil drückt das erste Gehäuseteil somit auf die Feedbackkomponente und bewegt gleichzeitig die erste Elektrode in Richtung der zweiten Elektrode der kapazitiven Druckmesseinrichtung, um so für eine kapazitive Druckmessung den Abstand zwischen den Elektroden zu verringern (oder den Abstand zu vergrößern, eine Elektrode zu verformen, Elektroden gegeneinander zu verschieben).

Die Druckmessung einer Feedbackkomponente wie einer Piezostruktur ist dynamisch, während die Druckmessung der kapazitiven Druckmesseinrichtung quasi statisch ist. Bei der kapazitiven Druckmessung ergibt sich bei einer Stellung der Elektroden zueinander ein bestimmter Druckmesswert, der sich nicht verändert, solange sich die Lage der Gehäuseteile/Elektroden zueinander nicht verändert. Dies ist als statisch zu bezeichnen. Die von beiden Komponenten ermittelten Druckmesswerte werden von der Kontrolleinheit geeignet verarbeitet, um so die Genauigkeit der Druckmessung zu erhöhen. In einer Ausführungsform der Erfindung ist die Kontrolleinheit daher dazu ausgebildet, aus Druckmesswerten der kapazitiven Druckmesseinrichtung und Druckmesswerten der Feedbackkomponente einen Referenzdruckwert für den Vergleich mit dem Grenzwert zu ermitteln.

Vorzugsweise kann die Funktionsweise der Aktuatoreinheit über die Kontrolleinheit konfiguriert werden, wobei konfiguriert werden kann, ob die Feedbackkomponente ergänzend zur Druckermittlung verwendet wird oder nicht. Die Druckmessung durch die Feedbackkomponente ist daher lediglich als optional anzusehen, die Aktuatoreinheit ist jedoch für diese Option ausgestaltet.

Um eine möglichst einfach aufgebaute Aktuatoreinheit bereitzustellen, die darüber hinaus leicht zu montieren ist, werden die Feedbackkomponente und die Druckmesseinrichtung vorzugsweise über ein gemeinsames Kontaktierungselement elektrisch mit der Kontrolleinheit kontaktiert. Dieses Kontaktierungselement dient wenigstens zur Ansteuerung der Feedbackkomponente durch die Kontrolleinheit und zum Anschluss der kapazitiven Druckmesseinrichtung an die Kontrolleinheit. Ergänzend kann es auch zum Anschluss der Feedbackkomponente dienen, um Druckmesswerte von der Feedbackkomponente an die Kontrolleinheit zu übermitteln. In einer vorteilhaften Ausführungsform der Erfindung umfasst das verwendete Kontaktierungselement ein flaches Band aus einem elektrisch isolierenden Material, auf dem mehrere Kontaktleitungen zur elektrischen Kontaktierung von Feedbackkomponente und Druckmesseinrichtung aufgebracht sind. Das bandförmige Kontaktierungselement kann dann über Anschlussstellen elektrisch mit der Feedbackkomponente und der Druckmesseinrichtung verbunden werden.

In einer Ausführungsform der Erfindung ist vorgesehen, dass das Kontaktierungselement auch die wenigstens zwei Elektroden der kapazitiven Druckmesseinrichtung ausbildet. Die Elektroden sind somit an dem Kontaktierungselement ausgebildet und werden bei der Montage des Kontaktierungselementes in die richtige Lage gebracht. Vorzugsweise wird dann die wenigstens eine Schicht eines Dielektrikums zwischen den beiden Elektroden durch das flache Band des Kontaktierungselementes gebildet. Das bandförmige Kontaktierungselement stellt so nicht nur die elektrische Kontaktierung für die Aktuatoreinheit bereit, sondern bildet gleichzeitig auch die wesentlichen Komponenten der kapazitiven Druckmesseinrichtung aus. Dies erleichtert erneut die Montage der Aktuatoreinheit und trägt zu ihrer Kompaktheit bei.

Dabei können die beiden Elektroden auf unterschiedliche Arten an dem Kontaktierungselement ausgebildet und positioniert sein. Beispielsweise bildet das flache Band des Kontaktierungselementes zwei Druckabschnitte aus, auf denen jeweils eine Elektrode ausgebildet ist. Eine Elektrode wird beispielsweise durch eine Kupferschicht gebildet, die auf das flache Band aufgebracht ist. Durch eine Verformung des flachen Bandes ist es dann möglich, die beiden Druckabschnitte mit den Elektroden so zueinander zu positionieren, dass sie in zwei Ebenen parallel zueinander liegen, wobei wenigstens eine Schicht aus dem flachen Band zwischen den beiden Elektroden liegt. Vorzugsweise liegen wenigstens zwei Schichten aus flachem Band zwischen den beiden Elektroden und bilden ein Dielektrikum.

In einer Ausführungsform der Erfindung ist das flache Band des Kontaktierungselementes beispielsweise durch Durchbrüche und/oder Einschnitte so ausgeformt, dass es wenigstens einen Laschenstreifen aufweist, der an einer Biegestelle aufeinander geklappt ist, wobei an den Enden des wenigstens einen Laschenstreifens jeweils ein Druckabschnitt ausgebildet ist, auf dem eine flächige Elektrode so angebracht ist, dass die beiden Druckabschnitte aus flachem Band zwischen den beiden Elektroden liegen. Insbesondere können zwei solcher Laschenstreifen vorgesehen sein, die an einer Biegestelle aufeinander geklappt sind. Bei der Fertigung des Kontaktierungselementes werden somit zwei Druckabschnitte ausgebildet, auf welchen Elektroden ausgebildet werden. Die Elektroden liegen dabei zunächst auf der gleichen Seite des flachen Bandes. Die beiden Druckabschnitte sind über wenigstens einen Laschenstreifen miteinander verbunden. Wird der wenigstens eine Laschenstreifen an einer Biegestelle umgeklappt, kommen die beiden Druckabschnitte parallel zueinander zum Liegen, wobei nun eine der beiden Elektroden auf der entgegengesetzten Seite des Kontaktierungselementes liegt. Die beiden Druckabschnitte liegen nun zwischen den beiden Elektroden.

Auf diese Weise kann das Kontaktierungselement einfach gefertigt werden, indem Kontaktleitungen und Elektroden nur auf einer Seite eines flachen Bandes aufgebracht werden müssen. Durch Umklappen des wenigstens einen Laschenstreifens werden die beiden Elektroden in die richtige Lage zueinander gebracht und das Kontaktierungselement kann montiert werden. Hierzu wird beispielsweise zunächst ein Druckabschnitt mit einer Elektrode mit einem Gehäuseteil verbunden und bei der Montage des anderen Gehäuseteils wird dieses mit dem anderen Druckabschnitt und damit der anderen Elektrode verbunden. Dies kann beispielsweise durch eine Klebeverbindung erfolgen. Die Verwendung eines solchen Kontaktierungselementes hat ferner den Vorteil, dass die kapazitive Druckmesseinrichtung und die Kontaktierung der Feedbackkomponente auf einfache Weise ungefähr in einer Ebene angeordnet werden können, was zur geringen Bauhöhe der erfindungsgemäßen Aktuatoreinheit beiträgt.

In einer Ausführungsform der Erfindung sind die beiden Gehäuseteile im Bereich der Elektroden, d.h. der kapazitiven Druckmesseinrichtung, gestuft ausgeführt. So können die Elektroden in Z-Richtung gesehen in einer anderen Ebene positioniert werden als die Feedbackkomponente. Die Biegestelle des wenigstens einen Laschenstreifens eines Kontaktierungselementes ist flexibel und nachgiebig, so dass sich die erste Elektrode gegenüber der zweiten Elektrode bewegen kann, ohne dass die Biegestelle bei Dauerbelastung bricht.

Um die Fertigung des Kontaktierungselementes und die Ausbildung der Druckabschnitte mit den Elektroden möglichst einfach zu gestalten, ist es beispielsweise ferner vorgesehen, dass das flache Band eine Aussparung aufweist, innerhalb welcher der wenigstens eine umgeklappte Laschenstreifen angeordnet ist, wobei Kontaktleitungen des Kontaktierungselementes um die Aussparung herum zu der Feedbacckomponente und den Elektroden der Druckmesseinrichtung verlaufen. Das flache Band des Kontaktierungselementes verbreitert sich dann optional im Bereich dieser Aussparung.

Von der Erfindung umfasst ist auch eine Mensch-Maschine-Schnittstelle mit einer Fläche, an welche wenigstens eine Aktuatoreinheit gemäß der Erfindung angebunden ist, um bei Druck auf die Fläche ein haptisches Feedback zu erzeugen und auf die Fläche zu übertragen. Die Mensch-Maschine-Schnittstelle weist die Kontrolleinheit auf, welche über die jeweiligen Kontaktierungsmittel mit einer oder mehreren Aktuatoreinheiten verbunden ist. Die Kontrolleinheit ist für den jeweiligen Anwendungsfall konfigurierbar. Beispielsweise sind in der Kontrolleinheit ein oder mehr Druck-Grenzwerte einstellbar.

Weitere Vorteile, Besonderheiten und zweckmäßige Weiterbildungen der Erfindung ergeben sich aus den Unteransprüchen und der nachfolgenden Darstellung bevorzugter Ausführungsbeispiele anhand der Abbildungen.

Von den Abbildungen zeigt:
- Fig. 1: eine schematische Schnittdarstellung einer ersten Ausführungsform einer erfindungsgemäßen Aktuatoreinheit;
- Fig. 2: eine schematische Schnittdarstellung einer zweiten Ausführungsform einer erfindungsgemäßen Aktuatoreinheit;
- Fig. 3: eine dreidimensionale Ansicht einer Ausführungsform einer Kontaktierung einer Aktuatoreinheit mit einem bandförmigen Kontaktierungselement;
- Fig. 4: einen schematischen Längsschnitt durch eine Kontaktierung gemäß Fig. 3;
- Fig. 5A: eine dreidimensionale Draufsicht auf ein Kontaktierungselement gemäß Fig. 3 im aufgeklappten Zustand;
- Fig. 5B: eine Rückansicht des Kontaktierungselementes gemäß Fig. 5A;
- Fig. 6A: eine dreidimensionale Draufsicht auf ein Kontaktierungselement gemäß Fig. 5A im zusammengeklappten Zustand;
- Fig. 6B: eine Rückansicht des Kontaktierungselementes gemäß Fig. 6A.

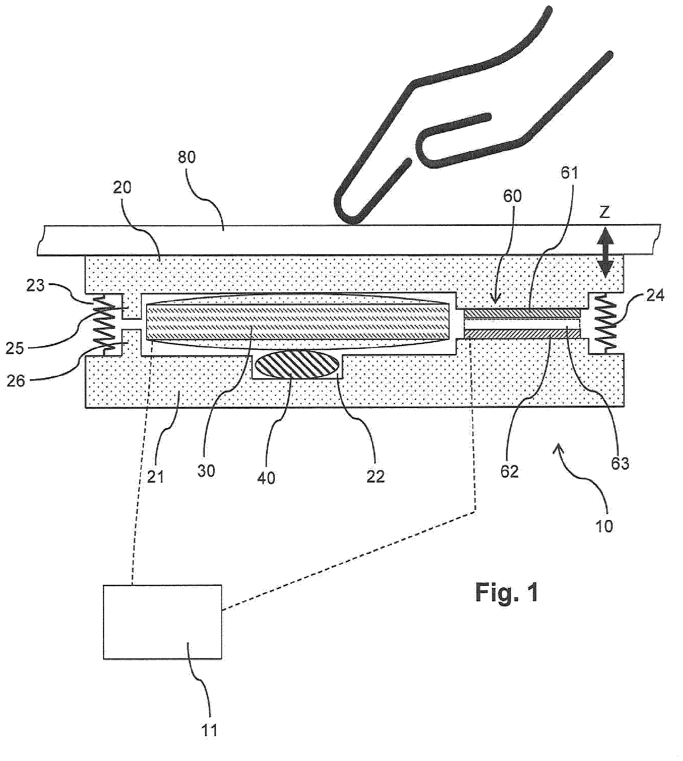

Fig. 1 zeigt eine schematische Schnittdarstellung einer ersten Ausführungsform einer erfindungsgemäßen Aktuatoreinheit 10 zur Erzeugung eines haptischen Feedbacks an einer Mensch-Maschine-Schnittstelle. Anhand dieser Prinzipdarstellung sollen die wesentlichen Komponenten und ihre Funktionen erläutert werden. Die Schnittstelle ist in den Figuren nicht vollständig dargestellt, sondern lediglich die Aktuatoreinheit 10 und eine Fläche 80 der Mensch-Maschine-Schnittstelle. Bei der Fläche 80 handelt es sich um eine druck- und/oder berührungssensitive Fläche. Ferner ist die Oberseite der Fläche 80 wie in den Ausführungsformen der Figuren eben ausgeführt. Sie kann jedoch auch andere Formen haben und beispielsweise gewölbt ausgeführt sein. Die Schnittstelle wird beispielsweise durch ein Touchpad oder einen Touchscreen gebildet. Die Aktuatoreinheit 10 wird über eine Kontrolleinheit 11 der Mensch-Maschine-Schnittstelle angesteuert, deren Anschluss in den Figuren schematisch mit einer gestrichelten Linie dargestellt ist. Ferner kann die Mensch-Maschine-Schnittstelle eine oder mehrere Aktuatoreinheiten aufweisen.

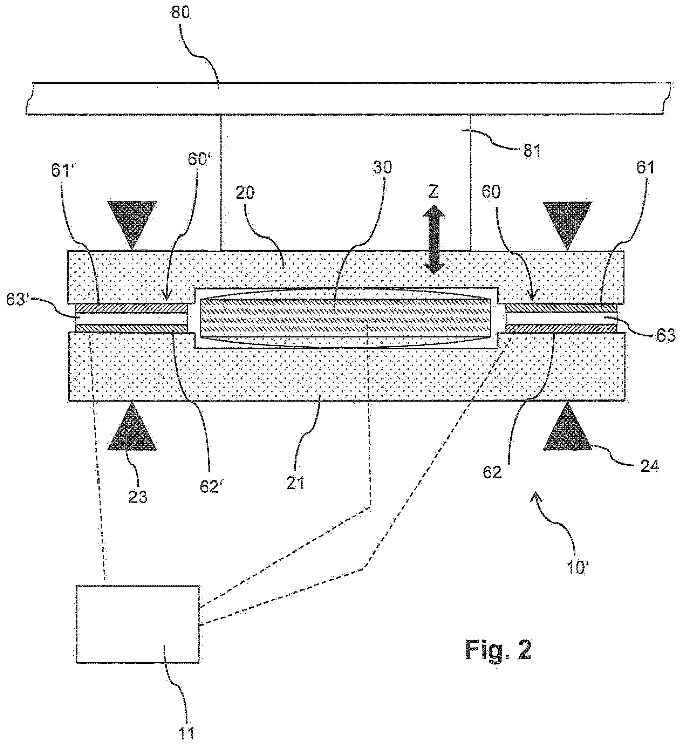

Die Ausführungsform der Fig. 1 sieht zwei Gehäuseteile 20 und 21 vor, die zusammen ein Gehäuse der Aktuatoreinheit 10 bilden, in welchem die wesentlichen Komponenten der Aktuatoreinheit 10 aufgenommen sind. Hierzu gehört eine Feedbacckomponente 30, die in dieser Ausführungsform eine Piezostruktur ist. Alternativ könnte beispielsweise auch eine Schwingspule (Voice Coil) gewählt werden. Das erste Gehäuseteil 20 ist auch als oberes Gehäuseteil zu bezeichnen und ist in Z-Richtung beweglich gegenüber einem zweiten Gehäuseteil 21, das folglich eine unteres Gehäuseteil bildet. In der Einbausituation steht das untere Gehäuseteil 21 dann fest, während das obere Gehäuseteil 21 die bewegliche Seite darstellt. Die mögliche Bewegung des oberen Gehäuseteils 20 ist in Fig. 1 durch einen Doppelpfeil dargestellt. Das obere Gehäuseteil 20 kann dabei gegenüber dem unteren Gehäuseteil 21 geführt sein. Zur prinzipiellen Erläuterung ist die Fläche 80 in dieser Ausführungsform direkt an das obere Gehäuseteil 20 angebunden, aber die mechanische Anbindung kann auch anders ausgeführt sein und beispielsweise weitere Zwischenelemente, Träger, Aufhängungen, etc. umfassen. Dies ist bei der Ausführungsform der Fig. 2 und dem Zwischenelement 81 der Fall, wobei dies erneut lediglich eine Prinzipdarstellung ist. Das Zwischenelement kann auch auf andere Arten realisiert werden.

Die Feedbackkomponente 30 ist zwischen den beiden Gehäuseteilen 20, 21 aufgenommen, wobei sich zwischen der Feedbackkomponente 30 und dem unteren Gehäuseteil 21 ein Dämpfungselement 40 befindet. Dieses Dämpfungselement 40 ist in einer Aussparung 22 im unteren Gehäuseteil 21 aufgenommen und ragt über den Öffnungsrand der Aussparung hinaus, um dort Kontakt mit der Unterseite der Feedbackkomponente 30 zu erhalten. Auf der Oberseite der Feedbackkomponente 30 liegt diese an einer Innenfläche des oberen Gehäuseteil 20 an.

Zwischen den beiden Gehäuseteilen 20, 21 ist ferner eine kapazitive Druckmesseinrichtung 60 ausgebildet. In Z-Richtung gesehen liegt diese Druckmesseinrichtung 60 neben der Feedbackkomponente 30, d.h. sie ist räumlich getrennt von ihr. Die Druckmesseinrichtung 60 umfasst zwei flächige Elektroden 61, 62 und ein dazwischen liegendes Dielektrikum 63. Eine erste Elektrode 61 ist mit dem ersten Gehäuseteil 20 verbunden, während eine zweite Elektrode 62 mit dem unteren Gehäuseteil 21 verbunden ist.

Erfolgt in Z-Richtung ein Druck auf die Fläche 80 (nicht maßstabsgerecht durch eine Hand dargestellt), wird dieser Druck auf das obere Gehäuseteil 20 übertragen, wodurch dieses Gehäuseteil 20 in Richtung des unteren Gehäuseteils 21 bewegt wird. Diese Bewegung wird optional durch einen Anschlag 25, 26 begrenzt. Der Abstand zwischen den beiden Elektroden 61, 62 der kapazitiven Druckmesseinrichtung 60 verringert sich und aus der gemessenen Kapazität bzw. ihrer Änderung kann die angeschlossene Kontrolleinheit 11 einen Druckmesswert ermitteln. Ist dieser Druckmesswert größer als ein bestimmter Grenzwert, wird der Druck auf die Fläche 80 als beabsichtigter Bediendruck eines Nutzers interpretiert. Die Kontrolleinheit 11 steuert daraufhin die Feedbackkomponente 30 an, an dem oberen Gehäuseteil 20 ein haptisches Feedback zu erzeugen. Dieses haptische Feedback wird von der oberen Gehäusehälfte 20 an die Fläche 80 übertragen.

Zur Erzeugung des haptischen Feedbacks wird z.B. eine Spannung an die Piezostruktur 30 angelegt, die durch den inversen piezoelektrischen Effekt in eine mechanische Kraft umgewandelt wird, welche die Piezostruktur 30 ausdehnt und dabei das obere Gehäuseteil 20 von dem unteren Gehäuseteil 21 weggedrückt. So bewegt sich das obere Gehäuseteil 20 aus einer Ruhelage in eine ausgelenkte Lage. Dies erfolgt gegen die Kraft einer oder mehrerer Spannkomponenten 23, 24. Diese sind beispielsweise als Federelemente ausgeführt, die unter Zugspannung zwischen den beiden Gehäuseteilen 20 und 21 eingespannt sind. Die Spannkomponenten wirken als Rückstellmechanismus, welcher das obere Gehäuseteil 20 nach seiner Auslenkung aus der Ruhelage wieder in diese zurückstellt. Zusammen mit dem Dämpfungselement 40 ergibt sich ein Schwingungssystem, das geeignet gewählt ist, um mit einer entsprechenden Anregung durch die Feedbackkomponente an der Fläche 80 die gewünschte Wahrnehmung für den Nutzer zu bewirken.

Fig. 2 zeigt eine schematische Schnittdarstellung einer zweiten Ausführungsform eine Aktuatoreinheit 10', die in wesentlichen Merkmalen mit der Ausführungsform der Fig. 1 übereinstimmt. Es sind jedoch zwei Druckmesseinrichtungen 60 und 60' vorgesehen, die auf gegenüber liegenden Seiten der Feedbackkomponente 30 angeordnet sind. Beide Druckmesseinrichtungen 60 60' weisen jeweils zwei Elektroden 61, 62 und 61', 62' auf, zwischen denen ein Dielektrikum 63, 63' liegt. In einer weiteren alternativen Ausführungsform handelt es sich um ringförmige Elektroden, welche die Feedbackkomponente 30 umgeben. Auch bei einer solchen Ausführungsform ist die Druckmesseinrichtung als räumlich getrennt von der Feedbackkomponente 30 anzusehen, da die ringförmigen Elektroden in Z-Richtung nicht mit der Feedbacckomponente 30 überlappen.

Ferner sind als Spannkomponenten 23, 24 keine Federelemente vorgesehen, welche zwischen den beiden Gehäuseteilen 20, 21 eingespannt sind. Vielmehr wirken Spannelemente 23, 24 durch den Einbau der Aktuatoreinheit 10' in ein elektronisches Gerät von außen auf die beiden Gehäuseteile 20, 21 und bewirken so eine Rückstellung des oberen Gehäuseteils 20 zurück in seine Ruhelage.

Bei den Ausführungsformen der Figuren 1 und 2 kann ferner vorgesehen sein, dass die jeweilige Feedbackkomponente 30 ergänzend zu der wenigstens einen kapazitiven Druckmesseinrichtung 60, 60' ebenfalls zur Druckmessung genutzt wird. Erfolgt ein Druck auf die Fläche 80 und damit auf das obere Gehäuseteil 20, erfährt auch die Feedbackkomponente 30 eine mechanische Kraft in Z-Richtung, welche die Feedbackkomponente 30 zusammendrückt. Dies wird durch den direkten piezoelektrischen Effekt in eine Spannung umgewandelt, aus welcher ein Druckmesswert ermittelbar ist. Die Kontrolleinheit 11 ist dann dazu ausgebildet, die Druckmesswerte von der Feedbackkomponente 30 und der wenigstens einen kapazitiven Druckmesseinrichtung 60, 60' auszuwerten, um insgesamt die Druckermittlung zu verbessern.

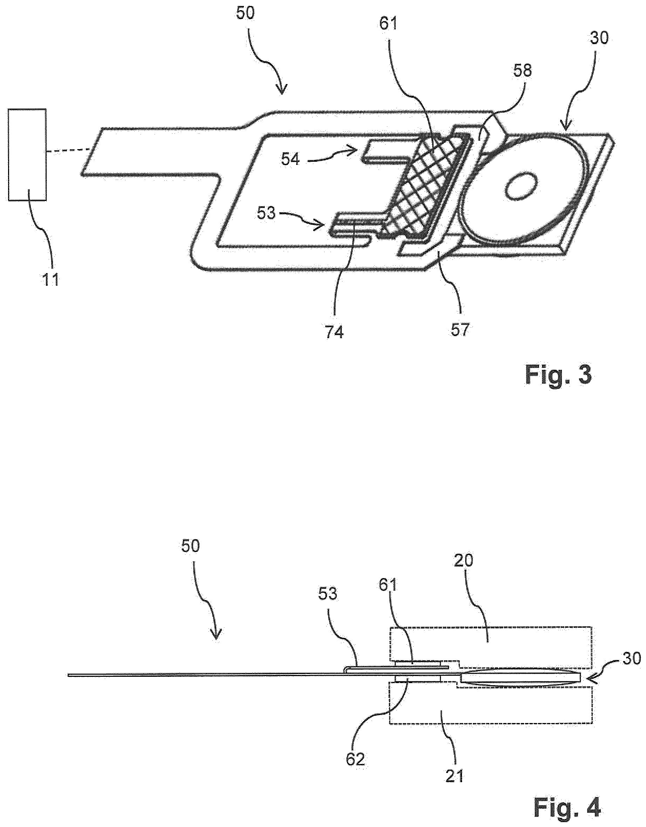

Die Ausführungsformen der Figuren 1 und 2 verdeutlichen, dass die erfindungsgemäße Aktuatoreinheit als kompaktes Bauteil ausgebildet werden kann, bei dem in einem Gehäuse aus zwei Gehäuseteilen auf einfache Art eine Feedbackkomponente und auch wenigstens eine kapazitive Druckmesseinrichtung untergebracht werden können. Die einzelnen Funktionskomponenten können an dem unteren Gehäuseteil 21 ausgerichtet werden, bevor das obere Gehäuseteil 20 montiert wird. Zur Kompaktheit und einfachen Montage kann auch eine geeignete Kontaktierung der Feedbackkomponente und der Druckmesseinrichtung mit der Kontrolleinheit 11 beitragen. Eine vorteilhafte Kontaktierung wird anhand der Figuren 3 und 4 erläutert.

Fig. 3 zeigt die Kontaktierung einer Feedbackkomponente 30 in Form einer Piezostruktur. Fig. 4 zeigt einen schematischen Längsschnitt durch diese Kontaktierung. Die Piezostruktur 30 wird elektrisch mit der Kontrolleinheit 11 verbunden, um diese ansteuern und optional auch Drucksingale von ihr empfangen zu können. Diese Kontaktierung erfolgt über ein spezielles Kontaktierungselement 50, welches gleichzeitig die Elektroden wenigstens einer kapazitiven Druckmesseinrichtung ausbildet. Der Zusammenbau der Fig. 1 kann vor oder nach der Anbringung der Feedbackkomponente 30 an einem unteren Gehäuseteil 21 erfolgen.

Das Kontaktierungselement 50 wird durch ein flaches Band aus einem elektrisch nichtleitenden Material gebildet, auf dem Kontaktleitungen zur Kontaktierung von Feedbackkomponente und kapazitiver Druckmesseinrichtung aufgebracht werden.

Für diese Kontaktleitungen wird beispielsweise Kupfer gewählt. Gleichzeitig bildet das flache Band wenigstens zwei Druckabschnitte auf, auf denen jeweils eine flächige Elektrode aufgebracht ist. Diese Elektroden können ebenfalls aus Kupfer ausgebildet sein. Das flache Band ist so verformt, dass die beiden flächigen Elektroden in zwei Ebenen parallel zueinander liegen, wobei sich zwischen den beiden Elektroden die Druckabschnitte aus dem Material des flachen Bandes befinden und so ein Dielektrikum bilden.

In der Darstellung der Fig. 3 befinden sich die Kontaktleitungen nicht sichtbar auf der Unterseite des Kontaktierungselementes 50, welches mit diesen Kontaktleitungen an die Kontrolleinheit 11 angeschlossen ist. Kontaktleitungen führen zu zwei endseitigen Kontaktlaschen 57 und 58 an dem flachen Band, die an die Piezostruktur 30 angeschlossen sind. Weitere Kontaktleitungen führen zu den zwei Elektroden, von denen in der Ansicht der Fig. 3 die obere Elektrode 61 sichtbar ist. Diese Elektrode 61 befindet sich am Ende von zwei Laschenstreifen 53, 54, die in ihrer Mitte umgeklappt sind. Auf einem Laschenstreifen 53 ist ein Leiter 74 von der Unterseite des flachen Bandes um die Biegestelle des Laschenstreifens 53 herum zu der Elektrode 61 geführt. Fig. 4 zeigt die andere Elektrode 62 auf der Unterseite des Kontaktierungselementes 50, die ebenfalls über einen Leiter kontaktiert ist.

Die beiden Elektroden 61, 62 sind so angeordnet, dass sie bei der Montage einer Aktuatoreinheit zwischen den beiden Gehäuseteilen liegen. Die Verbindung zu den Gehäuseteilen kann beispielsweise über eine Verklebung erfolgen. Die beiden Gehäusehälften 20, 21 sind in der Fig. 4 schematisch gestrichelt dargestellt.

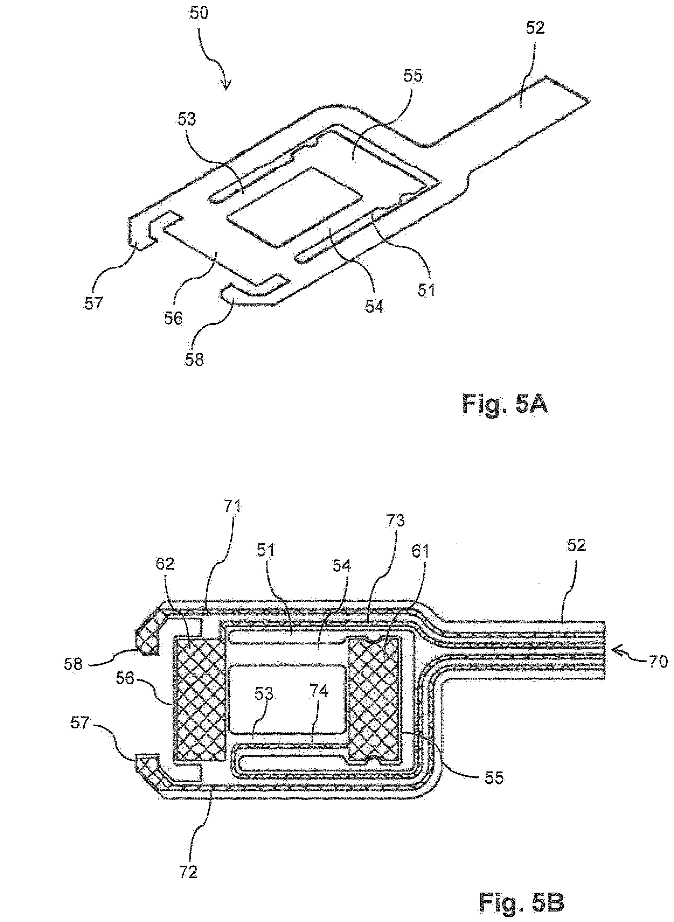

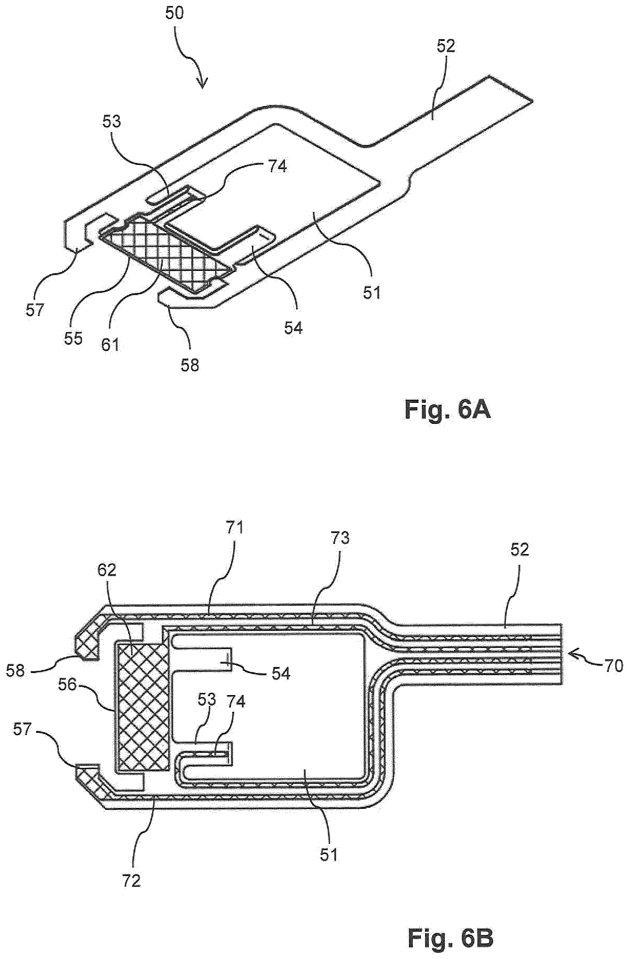

Das Kontaktierungselement 50 wird in zwei Stufen hergestellt. Zunächst werden Kontaktleitungen und Elektroden auf einer Seite des flachen Bandes ausgebildet. Anschließend wird wenigstens ein Laschenstreifen an einer Biegestelle umgeklappt, um die beiden Elektroden in eine Lage parallel zueinander zu bringen. Dieser Fertigungsvorgang wird anhand der Figuren 5A, 5B und 6A, 6B näher erläutert. Die Figuren 5A und 5B zeigen das Kontaktierungselement 50 in der ersten Fertigungsstufe, wobei Fig. 5A die Oberseite und Fig. 5B die Unterseite zeigt. Das flache Band des Kontaktierungselementes 50 bildet einen Zuführungsabschnitt 52 aus, auf dem alle Kontaktleitungen 70 verlaufen. Es bildet ferner eine Aussparung 51 aus, um welche diese Kontaktleitungen 70 wenigstens teilweise herum verlaufen. Zumindest zwei Leiter 71 und 72 verlaufen um die Aussparung 51 herum bis zu zwei Kontaktlaschen 57, 58 im Band, mit welchen die Feedbackkomponente kontaktiert wird.

Außerdem bildet das Band zwischen den beiden Kontaktlaschen 57, 58 einen ersten Druckabschnitt 56 aus, von dem zwei Laschenstreifen 53, 54 in die Aussparung 51 hineinragen. Am anderen Ende dieser Laschenstreifen 53, 54 ist ein weiterer Druckabschnitt 55 ausgebildet, welcher die beiden Laschenstreifen 53, 54 miteinander verbindet. Auf dem ersten Druckabschnitt 56 ist eine erste Elektrode 62 ausgebildet, die über einen Leiter 73 kontaktiert ist, der ebenfalls um die Aussparung 51 herum verläuft. Auf dem zweiten Druckabschnitt 55 ist eine zweite Elektrode 61 ausgebildet, die über einen Leiter 74 kontaktiert ist, der über den Laschenstreifen 53 zur Elektrode 61 verläuft.

Zur Ausbildung des endgültigen Kontaktierungselementes werden die Laschenstreifen 53, 54 an einer Biegestelle um etwa 180° umgeklappt. Dies erfolgt so, dass die beiden Elektroden 61, 62 anschließend im Wesentlichen parallel übereinander liegen. Fig. 6A zeigt das Ergebnis dieser zweiten Fertigungsstufe von der Oberseite, während Fig. 6B das resultierende Kontaktierungselement erneut von der Rückseite zeigt. Die Elektrode 61 liegt nun oben und wird um die Biegestelle des Laschenstreifens 53 herum von dem Leiter 74 kontaktiert, während die andere Elektrode 62 und die übrigen Kontaktleitungen 70 auf der gegenüber liegenden Seite des flachen Bandes liegen. Die beiden Druckabschnitte 55 und 56 liegen zwischen den beiden Elektroden 61, 62 und bilden ein Dielektrikum aus.

### Bezugszeichenliste:

- 10, 10': Aktuatoreinheit
- 11: Kontrolleinheit
- 20,21: Gehäuseteil
- 22: Aufnahme
- 23,24: Spannkomponente
- 25,26: Anschlag
- 30: Feedbackkomponente, Piezostruktur
- 40: Dämpfungselement
- 50: Kontaktierungselement
- 51: Aussparung
- 52: Zuführungsabschnitt
- 53,54: Laschenstreifen
- 55,56: Druckabschnitt
- 57,58: Kontaktlasche
- 60,60': Druckmesseinrichtung
- 61,61': Elektrode
- 62,62': Elektrode
- 63,63': Dielektrikum
- 70: Kontaktleitungen
- 71,72: Leiter für Feedbackkomponente
- 73,74: Leiter für Elektrode
- 80: Fläche
- 81: Zwischenelement

## Patentansprüche

1. Aktuatoreinheit (10;10') zur Erzeugung eines haptischen Feedbacks an einer Mensch-Maschine-Schnittstelle, aufweisend wenigstens:
- eine in Z-Richtung bewegliche Fläche;
- eine Druckmesseinrichtung (60) zur Messung eines Drucks in Z-Richtung auf diese bewegliche Fläche;
- eine Feedbackkomponente (30), die dazu ausgebildet ist, in Reaktion auf einen durch die Druckmesseinrichtung (60) gemessenen Druck ein haptisches Feedback auf die bewegliche Fläche zu übertragen;
- Kontaktierungsmittel zum Anschluss der Aktuatoreinheit (10;10') an eine Kontrolleinheit (11), die dazu ausgebildet ist, Druckmesswerte der Druckmesseinrichtung (60) zu empfangen und auszuwerten, und die Feedbackkomponente (30) anzusteuern, ein haptisches Feedback zu erzeugen, falls ein ermittelter Druckmesswert einen Grenzwert übersteigt;
**dadurch gekennzeichnet, dass**
- die Aktuatoreinheit (10; 10') wenigstens zwei Gehäuseteile (20;21) aufweist,
wodurch die Aktuatoreinheit (10;10') ein eigenständiges Bauteil ausbildet, welches als Funktionskomponente in ein elektronisches Gerät einbaubar ist und die beiden Gehäuseteile (20;21) ein Gehäuse für das Bauteil bilden;
- ein erstes Gehäusesteil (20) die bewegliche Fläche ausbildet, indem das erste Gehäuseteil (20) gegenüber einem zweiten Gehäuseteil (21) wenigstens in Z-Richtung beweglich angeordnet ist;
- die Feedbackkomponente (30) zwischen den beiden Gehäuseteilen (20;21) angeordnet ist, wobei sich die Feedbackkomponente (30) zur Bewegung des ersten Gehäuseteils (20) gegenüber dem zweiten Gehäuseteil (21) an dem zweiten Gehäuseteil (21) abstützt; und
- die Druckmesseinrichtung (60) zur Messung eines Drucks in Z-Richtung auf das bewegliche Gehäuseteil (20) ausgebildet ist, wobei die Druckmesseinrichtung (60) eine kapazitive Messeinrichtung ist, die räumlich getrennt von der Feedbackkomponente (30) zwischen den beiden Gehäuseteilen (20;21) angeordnet ist, um durch eine Bewegung des beweglichen ersten Gehäuseteils (20) gegenüber dem zweiten Gehäuseteil (21) in Z-Richtung eine kapazitive Druckmessung zu bewirken.

2. Aktuatoreinheit nach Anspruch 1,
**dadurch gekennzeichnet, dass** die Feedbackkomponente (30) eine Piezostruktur oder Schwingspule umfasst, die dazu ausgebildet ist, eine Bewegung des ersten Gehäuseteils (20) in Z-Richtung zu bewirken.

3. Aktuatoreinheit nach einem oder beiden der Ansprüche 1 und 2,
**dadurch gekennzeichnet, dass** sie einen Rückstellmechanismus umfasst, der dazu ausgebildet ist, das erste Gehäuseteil (20) nach einer Auslenkung aus seiner Ruhelage in eine ausgelenkte Lage in seine Ruhelage rückzustellen.

4. Aktuatoreinheit nach Anspruch 3,
**dadurch gekennzeichnet, dass** der Rückstellmechanismus wenigstens ein Federelement umfasst, das unter Zugspannung zwischen dem ersten Gehäuseteil (20) und dem zweiten Gehäuseteil (21) eingespannt ist.

5. Aktuatoreinheit nach einem oder mehreren der Ansprüche 1 bis 4,
**dadurch gekennzeichnet, dass** zwischen der Feedbackkomponente (30) und dem zweiten Gehäuseteil (21) wenigstens ein Dämpfungselement (40) angeordnet ist.

6. Aktuatoreinheit nach Anspruch 5,
**dadurch gekennzeichnet, dass** das Dämpfungselement (40) wenigstens teilweise in einer Aufnahme (22) innerhalb des zweiten Gehäuseteils (21) aufgenommen ist.

7. Aktuatoreinheit nach einem oder mehreren der Ansprüche 1 bis 6,
**dadurch gekennzeichnet, dass** die Druckmesseinrichtung (60) wenigstens eine erste Elektrode (61) aufweist, die mit dem ersten beweglichen Gehäuseteil (20) verbunden ist, und wenigstens eine zweite Elektrode (62), die mit dem zweiten Gehäuseteil (21) verbunden ist, wobei sich zwischen den beiden Elektroden (61;62) wenigstens eine Schicht aus einem Dielektrikum befindet.

8. Aktuatoreinheit nach einem oder mehreren der Ansprüche 1 bis 7,
**dadurch gekennzeichnet, dass** die Feedbackkomponente (30) ergänzend zur Erzeugung eines haptischen Feedbacks auch zur Messung eines Drucks auf das erste Gehäuseteil (20) in Z-Richtung ausgebildet ist.

9. Aktuatoreinheit nach Anspruch 8,
**dadurch gekennzeichnet, dass** die Kontrolleinheit (11) dazu ausgebildet ist, aus Druckmesswerten der kapazitiven Druckmesseinrichtung (60) und Druckmesswerten der Feedbackkomponente (30) einen Referenzdruckwert für den Vergleich mit dem Grenzwert zu ermitteln.

10. Aktuatoreinheit nach einem oder mehreren der Ansprüche 1 bis 9,
**dadurch gekennzeichnet, dass** die Feedbackkomponente (30) und die Druckmesseinrichtung (60) über ein gemeinsames Kontaktierungselement (50) elektrisch mit der Kontrolleinheit (11) kontaktierbar sind, wobei das Kontaktierungselement (50) ein flaches Band aus einem elektrisch isolierenden Material umfasst, auf dem mehrere Kontaktleitungen (70) zur elektrischen Kontaktierung von Feedbackkomponente (30) und Druckmesseinrichtung (60) aufgebracht sind.

11. Aktuatoreinheit nach einem der Ansprüche 7 bis 10,
**dadurch gekennzeichnet, dass** das Kontaktierungselement (50) die wenigstens zwei Elektroden (61;62) der Druckmesseinrichtung (60) ausbildet, wobei wenigstens eine Schicht eines Dielektrikums zwischen den beiden Elektroden (61;62) durch das flache Band des Kontaktierungselementes (50) gebildet ist.

12. Aktuatoreinheit nach Anspruch 11,
**dadurch gekennzeichnet, dass** das flache Band des Kontaktierungselementes (50) durch Durchbrüche und/oder Einschnitte so ausgeformt ist, dass es wenigstens einen Laschenstreifen (53;54) aufweist, der an einer Biegestelle aufeinander geklappt ist, wobei an den Enden des wenigstens einen Laschenstreifens (53;54) jeweils ein Druckabschnitt (55;56) ausgebildet ist, auf dem eine flächige Elektrode (61;62) so angebracht ist, dass die beiden Druckabschnitte (55;56) zwischen den beiden Elektroden (61;62) liegen.

13. Aktuatoreinheit nach Anspruch 12,
**dadurch gekennzeichnet, dass** das flache Band eine Aussparung (51) aufweist, innerhalb welcher der wenigstens eine Laschenstreifen (53;54) angeordnet, wobei Kontaktleitungen (70) des Kontaktierungselementes (50) um die Aussparung (51) herum zu der Feedbackkomponente (30) und den Elektroden (61;62) der Druckmesseinrichtung (60) verlaufen.

14. Aktuatoreinheit nach einem oder mehreren der Ansprüche 1 bis 13,
**dadurch gekennzeichnet, dass** die Druckmesseinrichtung (60) und die Feedbackkomponente (30) in Z-Richtung gesehen nebeneinander angeordnet sind.

## Claims

1. Actuator unit (10; 10') for generating haptic feedback at a human-machine interface, having at least:
- a surface that is movable in the Z direction;
- a pressure-measuring device (60) for measuring a pressure in the Z direction on this movable surface;
- a feedback component (30), which is designed to transmit haptic feedback to the movable surface in response to a pressure measured by the pressure-measuring device (60);
- contacting means for connecting the actuator unit (10; 10') to a control unit (11), which is designed to receive and to evaluate pressure measurement values of the pressure-measuring device (60) and to actuate the feedback component (30) to generate haptic feedback if a determined pressure measurement value exceeds a limit value;
**characterized in that**
- the actuator unit (10; 10') has at least two housing parts (20; 21), as a result of which the actuator unit (10; 10') forms a stand-alone component, which can be installed into an electronic device as a functional component, and the two housing parts (20; 21) form a housing for the component;
- a first housing part (20) forms the movable surface by way of the first housing part (20) being arranged movably in relation to a second housing part (21) at least in the Z direction;
- the pressure-measuring device (60) is designed to measure a pressure in the Z direction on the movable housing part (20), wherein the pressure-measuring device (60) is a capacitive measuring device which is arranged between the two housing parts (20; 21) in a manner spatially separated from the feedback component (30) in order to cause a capacitive pressure measurement owing to the movable first housing part (20) moving in relation to the second housing part (21) in the Z direction.

2. Actuator unit according to Claim 1,
**characterized in that** the feedback component (30) comprises a piezo structure or oscillator coil, which is designed to cause the first housing part (20) to move in the Z direction.

3. Actuator unit according to one or both of Claims 1 and 2,
**characterized in that** it comprises a return mechanism, which is designed to return the first housing part (20) to its neutral position following a deflection from its neutral position to a deflected position.

4. Actuator unit according to Claim 3,
**characterized in that** the return mechanism comprises at least one spring element, which is clamped under tension between the first housing part (20) and the second housing part (21).

5. Actuator unit according to one or more of Claims 1 to 4,
**characterized in that** at least one damping element (40) is arranged between the feedback component (30) and the second housing part (21).

6. Actuator unit according to Claim 5,
**characterized in that** the damping element (40) is at least partially received in a receptacle (22) within the second housing part (21).

7. Actuator unit according to one or more of Claims 1 to 6,
**characterized in that** the pressure-measuring device (60) has at least one first electrode (61), which is connected to the first movable housing part (20), and at least one second electrode (62), which is connected to the second housing part (21), wherein there is at least one layer of a dielectric between the two electrodes (61; 62).

8. Actuator unit according to one or more of Claims 1 to 7, **characterized in that** the feedback component (30), in addition to generating haptic feedback, is also designed to measure a pressure on the first housing part (20) in the Z direction.

9. Actuator unit according to Claim 8,
**characterized in that** the control unit (11) is designed to determine a reference pressure value for comparison with the limit value from pressure measurement values of the capacitive pressure-measuring device (60) and pressure measurement values of the feedback component (30).

10. Actuator unit according to one or more of Claims 1 to 9,
**characterized in that** the feedback component (30) and the pressure-measuring device (60) can be electrically contact-connected to the control unit (11) via a common contacting element (50), wherein the contacting element (50) comprises a flat strip composed of an electrically insulating material, on which a plurality of contact lines (70) for electrically contacting the feedback component (30) and the pressure-measuring device (60) are applied.

11. Actuator unit according to any of Claims 7 to 10, **characterized in that** the contacting element (50) forms the at least two electrodes (61; 62) of the pressure-measuring device (60), wherein at least one layer of a dielectric between the two electrodes (61; 62) is formed by the flat strip of the contacting element (50).

12. Actuator unit according to Claim 11,
**characterized in that** the flat strip of the contacting element (50) is formed, by apertures and/or incisions, such that it has at least one tab strip (53; 54), which is folded up at a bending point, wherein a pressure portion (55; 56) is formed at each of the ends of the at least one tab strip (53; 54), a flat electrode (61; 62) being attached to the pressure portion such that the two pressure portions (55; 56) are situated between the two electrodes (61; 62).

13. Actuator unit according to Claim 12,
**characterized in that** the flat strip has a recess (51) within which the at least one tab strip (53; 54) is arranged, wherein contact lines (70) of the contacting element (50) are routed around the recess (51) to the feedback component (30) and the electrodes (61; 62) of the pressure-measuring device (60).

14. Actuator unit according to one or more of Claims 1 to 13,
**characterized in that** the pressure-measuring device (60) and the feedback component (30) are arranged next to each other as viewed in the Z direction.

## Revendications

1. Unité formant actionneur (10 ; 10') destinée à générer un retour haptique au niveau d'une interface homme-machine, ladite unité comportant au moins :
- une surface mobile dans la direction Z ;
- un dispositif de mesure de pression (60) destiné à mesurer une pression dans la direction Z sur cette surface mobile ;
- un composant de retour (30) qui est conçu pour transmettre un retour haptique à la surface mobile en réponse à une pression mesurée par le dispositif de mesure de pression (60) ;
- des moyens de contact destinés à raccorder l'unité formant actionneur (10 ; 10') à une unité de commande (11), qui est conçue pour recevoir et évaluer des valeurs de mesure de pression du dispositif de mesure de pression (60), et commander le composant de retour (30), afin de générer un retour haptique si une valeur de mesure de pression déterminée dépasse une valeur limite ;
**caractérisée en ce que**
- l'unité formant actionneur (10 ; 10') comporte au moins deux parties de boîtier (20 ; 21), permettant à l'unité formant actionneur (10 ; 10') de former un composant indépendant qui peut être installé comme composant fonctionnel dans un appareil électronique et les deux parties de boîtier (20 ; 21) forment un boîtier destiné au composant ;
- une première partie de boîtier (20) forme la surface mobile dans la mesure où la première partie de boîtier (20) est disposée de manière mobile par rapport à une deuxième partie de boîtier (21) au moins dans la direction Z ;
- le composant de retour (30) est disposé entre les deux parties de boîtier (20 ; 21), le composant de retour (30) venant en appui sur la deuxième partie de boîtier (21) afin de déplacer la première partie de boîtier (20) par rapport à la deuxième partie de boîtier (21) ; et
- le dispositif de mesure de pression (60) est conçu pour mesurer une pression exercée dans la direction Z sur la partie de boîtier mobile (20), le dispositif de mesure de pression (60) étant un dispositif de mesure capacitif qui est disposé entre les deux parties de boîtier (20 ; 21) de manière à être séparé spatialement du composant de retour (30) afin d'effectuer une mesure de pression capacitive dans la direction Z par mouvement de la première partie de boîtier mobile (20) par rapport à la deuxième partie de boîtier (21).

2. Unité formant actionneur selon la revendication 1, **caractérisée en ce que** le composant de retour (30) comprend une structure piézoélectrique ou une bobine oscillante qui est conçue pour provoquer un mouvement de la première partie de boîtier (20) dans la direction Z.

3. Unité formant actionneur selon l'une des revendications 1 et 2 ou les deux,
**caractérisée en ce qu'**elle comprend un mécanisme de rappel qui est conçu pour ramener la première partie de boîtier (20) dans sa position de repos après une déviation de sa position de repos vers une position déviée.

4. Unité formant actionneur selon la revendication 3, **caractérisée en ce que** le mécanisme de rappel comprend au moins un élément à ressort qui est serré sous tension de traction entre la première partie de boîtier (20) et la deuxième partie de boîtier (21).

5. Unité formant actionneur selon une ou plusieurs des revendications 1 à 4,
**caractérisée en ce qu'**au moins un élément amortisseur (40) est disposé entre le composant de retour (30) et la deuxième partie de boîtier (21).

6. Unité formant actionneur selon la revendication 5, **caractérisée en ce que** l'élément amortisseur (40) est logé au moins partiellement dans un logement (22) ménagé à l'intérieur de la deuxième partie de boîtier (21).

7. Unité formant actionneur selon une ou plusieurs des revendications 1 à 6,
**caractérisée en ce que** le dispositif de mesure de pression (60) comporte au moins une première électrode (61) qui est reliée à la première partie de boîtier mobile (20), et au moins une deuxième électrode (62) qui est reliée à la deuxième partie de boîtier (21), au moins une couche d'un diélectrique étant située entre les deux électrodes (61 ; 62).

8. Unité formant actionneur selon une ou plusieurs des revendications 1 à 7,
**caractérisée en ce que**, en plus de générer un retour haptique, le composant de retour (30) est conçu pour mesurer une pression exercée sur la première partie de boîtier (20) dans la direction Z.

9. Unité formant actionneur selon la revendication 8, **caractérisée en ce que** l'unité de commande (11) est conçue pour déterminer, à partir de valeurs de mesure de pression du dispositif de mesure de pression capacitif (60) et de valeurs de mesure de pression du composant de retour (30), une valeur de pression de référence destinée à être comparée à la valeur limite.

10. Unité formant actionneur selon une ou plusieurs des revendications 1 à 9,
**caractérisée en ce que** le composant de retour (30) et le dispositif de mesure de pression (60) peuvent être mis en contact électrique avec l'unité de commande (11) par le biais d'un élément de contact commun (50), l'élément de contact commun (50) comprenant une bande plate de matériau électriquement isolant, sur laquelle une pluralité de lignes de contact (70) sont appliquées afin de venir en contact électrique avec le composant de retour (30) et le dispositif de mesure de pression (60) .

11. Unité formant actionneur selon l'une des revendications 7 à 10,
**caractérisée en ce que** l'élément de contact (50) forme les au moins deux électrodes (61 ; 62) du dispositif de mesure de pression (60), au moins une couche d'un diélectrique entre les deux électrodes (61 ; 62) étant formée par la bande plate de l'élément de contact (50).

12. Unité formant actionneur selon la revendication 11,
**caractérisée en ce que** la bande plate de l'élément de contact (50) est formée par des ouvertures et/ou des incisions de sorte qu'elle comporte au moins une patte d'attache (53 ; 54) qui est repliée sur elle-même/les unes sur les autres au niveau d'un point de courbure, une portion de pression (55 ; 56) étant formée aux extrémités de l'au moins une patte d'attache (53 ; 54), sur laquelle une électrode plate (61 ; 62) est fixée de telle sorte que les deux portions de pression (55 ; 56) soient situées entre les deux électrodes (61 ; 62).

13. Unité formant actionneur selon la revendication 12,
**caractérisée en ce que** la bande plate comporte un évidement (51) à l'intérieur duquel est disposée l'au moins une patte d'attache (53 ; 54), des lignes de contact (70) de l'élément de contact (50) s'étendant autour de l'évidement (51) jusqu'au composant de retour (30) et aux électrodes (61 ; 62) du dispositif de mesure de pression (60).

14. Unité formant actionneur selon une ou plusieurs des revendications 1 à 13,
**caractérisée en ce que** le dispositif de mesure de pression (60) et le composant de retour (30) sont disposés l'un à côté de l'autre lorsqu'on les regarde dans la direction Z.
